# EUROPEAN PATENT APPLICATION

(11) **EP 3 316 318 A1**
(43) Date of publication of application: **02.05.2018**
(21) Application number: 17193467.2
(22) Date of filing: 27.09.2017
(51) Int. Cl.: H01L 31/05, H01L 31/18

(54) **APPARATUS FOR PROCESSING OF SOLAR CELLS, SYSTEM FOR THE MANUFACTURE OF SOLAR CELLS, AND METHOD FOR TESTING SOLAR CELLS**

(30) Priority: 28.10.2016 CN 201610969775; 28.10.2016 CN 201621194051 U
(71) Applicant: APPLIED MATERIALS ITALIA S.R.L., 31048 San Biagio di Callalta (TV) (IT)
(72) Inventor: Cellere, Giorgio, 36040 Torri di Quartesolo (IT)
(74) Representative: Zimmermann & Partner Patentanwälte mbB

(57) **Abstract**

An apparatus (100) for processing of solar cells (10) is provided. The apparatus (100) includes a dual-line transport arrangement (110) having a first transport line (112) and a second transport line (114) configured for transportation of the solar cells (10), at least one first process station (120) at the dual-line transport arrangement (110), a single-line transport arrangement (130) having a third transport line (132) configured for transportation of the solar cells (10), at least one second process station (122) at the single-line transport arrangement (130), and a transfer module (140) between the at least one first process station (120) and the at least one second process station (122). The transfer module (140) is configured for transferring the solar cells (10) from the first transport line (112) and the second transport line (114) to the third transport line (132).

## Description

### FIELD

Embodiments of the present disclosure relate to an apparatus for processing of solar cells, a system for the manufacture of solar cells, and a method for testing solar cells. Embodiments of the present disclosure particularly relate to an apparatus, a system and a method for electrical testing and optical inspection of solar cells.

### BACKGROUND

Solar cells are photovoltaic (PV) devices that convert sunlight directly into electrical power. An apparatus for processing of solar cells may have a line configuration with multiple transport lines, wherein a plurality of process stations can be provided along the transport lines. In order to increase a throughput of the apparatus, a plurality of transport lines can be arranged in parallel, each transport line having respective process stations. Such an apparatus consumes considerable space for installation. Further, costs are generated, e.g., in regard to operation and maintenance.

In view of the above, new apparatuses for processing of solar cells, systems for the manufacture of solar cells, and methods for testing solar cells that overcome at least some of the problems in the art are beneficial. The present disclosure particularly aims at providing an apparatus, system and method that can at least one of reduce a footprint and provide a high throughput.

### SUMMARY

In light of the above, an apparatus for processing of solar cells, a system for the manufacture of solar cells, and a method for testing solar cells are provided. Further aspects, benefits, and features of the present disclosure are apparent from the claims, the description, and the accompanying drawings.

According to an aspect of the present disclosure, an apparatus for processing of solar cells is provided. The apparatus includes a dual-line transport arrangement having a first transport line and a second transport line configured for transportation of the solar cells, at least one first process station at the dual-line transport arrangement, a single-line transport arrangement having a third transport line configured for transportation of the solar cells, at least one second process station at the single-line transport arrangement, and a transfer module between the at least one first process station and the at least one second process station. The transfer module is configured for transferring the solar cells from the first transport line and the second transport line to the third transport line, or vice versa.

According to a further aspect of the present disclosure, a system for the manufacture of solar cells is provided. The system includes one or more production stations for producing solar cells, and the apparatus for processing of solar cells according to the embodiments described herein. The apparatus is configured for testing and/or inspection of solar cells produced by the one or more production stations.

According to another aspect of the present disclosure, a method for testing solar cells is provided. The method includes performing a first testing procedure on the solar cells arranged on a first transport line and a second transport line of a dual-line transport arrangement, moving the solar cells positioned on the first transport line and the second transport line to a third transport line of a single-line transport arrangement, and performing a second testing procedure on the solar cells arranged on the third transport line.

Embodiments are also directed at apparatuses for carrying out the disclosed method and include apparatus parts for performing each described method aspect. These method aspects may be performed by way of hardware components, a computer programmed by appropriate software, by any combination of the two or in any other manner. Furthermore, embodiments according to the disclosure are also directed at methods for operating the described apparatus. The methods for operating the described apparatus include method aspects for carrying out every function of the apparatus.

### BRIEF DESCRIPTION OF THE DRAWINGS

So that the manner in which the above recited features of the present disclosure can be understood in detail, a more particular description of the disclosure, briefly summarized above, may be had by reference to embodiments. The accompanying drawings relate to embodiments of the disclosure and are described in the following:
- FIG. 1A: shows a schematic top view of an apparatus for processing of solar cells according to embodiments described herein;
- FIGs. 1B and C: show schematic views of a transfer of solar cells from the first transport line and the second transport line to the third transport line according to embodiments described herein;
- FIG. 2: shows a schematic side view of a transfer module for transferring solar cells between transport lines according to embodiments described herein;
- FIG. 3: shows a schematic top view of an apparatus for processing of solar cells according to further embodiments described herein;
- FIG. 4: shows a schematic top view of an apparatus for processing of solar cells according to yet further embodiments described herein;
- FIG. 5: shows a schematic top view of a system for the manufacture of solar cells according to embodiments described herein; and
- FIG. 6: shows a flow chart of a method for testing solar cells according to embodiments described herein.

### DETAILED DESCRIPTION OF EMBODIMENTS

Reference will now be made in detail to the various embodiments of the disclosure, one or more examples of which are illustrated in the figures. Within the following description of the drawings, the same reference numbers refer to same components. Generally, only the differences with respect to individual embodiments are described. Each example is provided by way of explanation of the disclosure and is not meant as a limitation of the disclosure. Further, features illustrated or described as part of one embodiment can be used on or in conjunction with other embodiments to yield yet a further embodiment. It is intended that the description includes such modifications and variations.

In an apparatus for processing of solar cells, two transport lines can be provided for parallel processing of a plurality of solar cells. A plurality of process stations are provided along each of the transport lines. Each process station can be provided twice, i.e., one for each of the two transport lines. Providing a respective process station for each of the transport lines increases a footprint of the apparatus and consumes considerable space for installation. Further, costs are generated, e.g., in regard to operation and maintenance, since each of the process stations is present twice.

The present disclosure uses a combination of a dual-line transport arrangement and a single-line transport arrangement with a transfer module arranged therebetween. The dual-line transport arrangement and the single-line transport arrangement can be sequentially arranged, wherein the transfer module moves solar cells from the dual-line transport arrangement to the single-line transport arrangement. A footprint of the apparatus, a space for installation, and/or costs can be reduced. Further, one or more process stations having a high throughput rate can be arranged along the single-line transport arrangement and/or one or more process stations having a lower throughput rate can be arranged along the dual-transport arrangement. An overall throughput of the apparatus can thus be high.

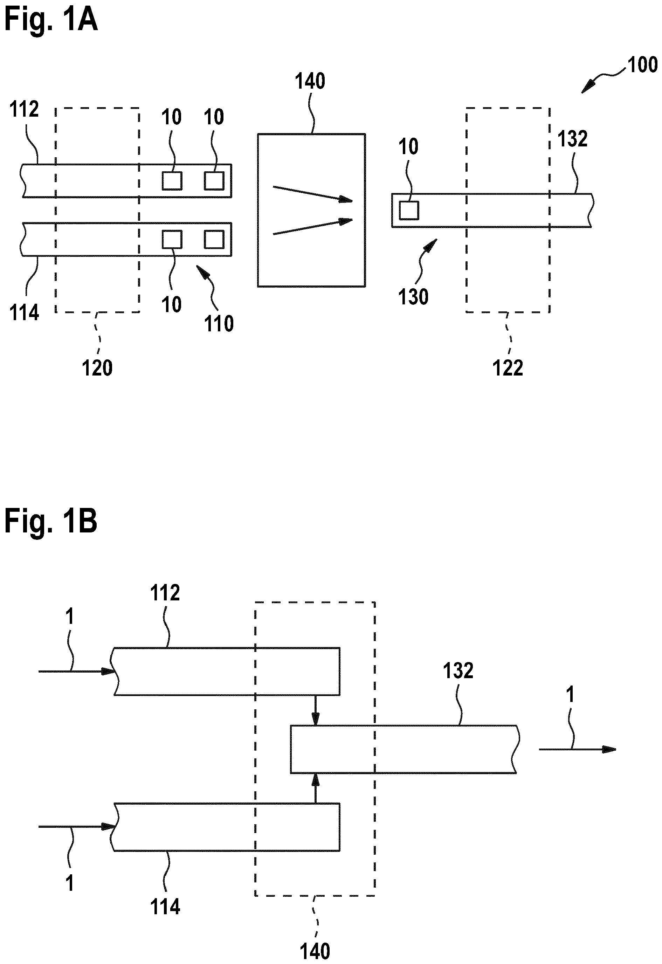

FIG. 1A shows a schematic view of an apparatus 100 for processing of solar cells 10 according to embodiments described herein.

The apparatus 100 includes a dual-line transport arrangement 110 having a first transport line 112 and a second transport line 114 configured for transportation of the solar cells 10, at least one first process station 120 at the dual-line transport arrangement 110, a single-line transport arrangement 130 having a third transport line 132 configured for transportation of the solar cells 10, at least one second process station 122 at the single-line transport arrangement 130, and a transfer module 140 between the at least one first process station 120 and the at least one second process station 122. The transfer module 140 is configured for transferring or moving the solar cells 10 from the first transport line 112 and the second transport line 114 to the third transport line 132, and/or vice versa.

According to some embodiments, the first transport line 112 and the second transport line 114 extend at least partially, e.g., entirely, through the at least one first process station 120. Likewise, the third transport line 132 extends at least partially, e.g., entirely, through the at least one second process station 122. The first transport line 112, the second transport line 114 and/or the third transport line 132 can be, for example, conveyors, such as belt conveyors. The first transport line 112 and the second transport line 114 can extend next to each other and/or substantially parallel to each other. In some implementations, the third transport line 132 and at least one of the first transport line 112 and the second transport line 114 can extend substantially parallel to each other. As an example, a transport direction for the solar cells 10 provided by at least some of the transport lines can be substantially parallel. The first transport line 112, the second transport line 114 and/or the third transport line 132 can be linear transport lines.

The term "substantially parallel" relates to a substantially parallel orientation e.g. of the transport lines and/or the transport directions, wherein a deviation of a few degrees, e.g. up to 1° or even up to 5°, from an exact parallel orientation is still considered as "substantially parallel". The deviation could be caused by, for example, manufacturing tolerances of the apparatus.

According to some embodiments, which can be combined with other embodiments described herein, the at least one first process station 120 can be selected from the group consisting of an electrical testing station, an optical inspection station, a printing station, a drying station, a sorting station, and any combination thereof. Likewise, the at least one second process station 122 can be selected from the group consisting of an electrical testing station, an optical inspection station, a printing station, a drying station, a sorting station, and any combination thereof. As an example, the at least one first process station 120 can include an electrical testing station, and the at least one second process station 122 can include an optical inspection station, such as an automatic optical inspection (AOI) station. The at least one first process station 120 can be one or more first process stations. The at least one second process station 122 can be one or more second process stations. Specifically, more than one first process stations can be arranged at the dual-line transport arrangement 110. Likewise, more than one second process stations can be provided at the single-line transport arrangement 130.

The electrical testing station can be configured to perform tests and/or inspections on the solar cells 10. According to some embodiments, the electrical testing station can be configured to determine solar parameters including, but not limited to, at least one of an open circuit voltage (Voc), a short circuit current (Isc), a maximum power (Pmax), an efficiency, and a fill factor of the solar cells 10.

The electrical testing station can include a light source, such as a solar simulator, configured to emit an electromagnetic radiation towards the solar cells 10. The light source can include a radiation plate that is divided into a plurality of cells, and each of the cells includes a plurality of light emitting elements, e.g. LEDs, emitting different wavelengths to provide an output spectrum simulating the spectrum of solar radiation. A light source controller can be connected to the light source. According to some embodiments, the light source controller can be configured to control the light source, for instance, based on preset conditions or parameters, such as kind of solar cells to be tested, test conditions, and the like.

According to some embodiments, the electrical testing station includes contact elements to provide electrical connections to the solar cells 10. For instance, two pairs of contact elements could be provided, wherein each pair may include a front contact and a back contact for contacting a front surface and a back surface, respectively, of a solar cell. The first pair may be configured to measure a voltage or voltage drop, and the second pair may be configured to measure a current, so as to enable, for instance, electronic load I-V measurements.

In some implementations, the optical inspection station can be an AOI station configured to perform an optical inspection of the solar cells. For example, the optical inspection station can include one or more cameras, such as high-resolution cameras, configured to obtain images of the solar cells for optical inspection. The optical inspection station can be configured for inspecting at least one of a positioning of conductive lines of the solar cells, a printing quality of the conductive lines, a geometry of the conductive lines, a structural condition of the solar cell including, but not limited to, cracks or micro cracks of the solar cell or solar cell wafer, and a color of the solar cells.

The printing station can be configured for printing, such as screen printing, of conductive patterns on solar cell substrates used in the manufacture of the solar cells. The conductive patterns can be selected from the group consisting of fingers, busbars, and any combinations thereof. As an example, the printing station can be configured for double-printing. The drying station can be configured for drying material deposited on the solar cell substrate in the printing station. As an example, the drying station can be an oven. The sorting station can be configured for sorting solar cells based on testing results obtained through, for example, the electrical testing station and/or the optical inspection station.

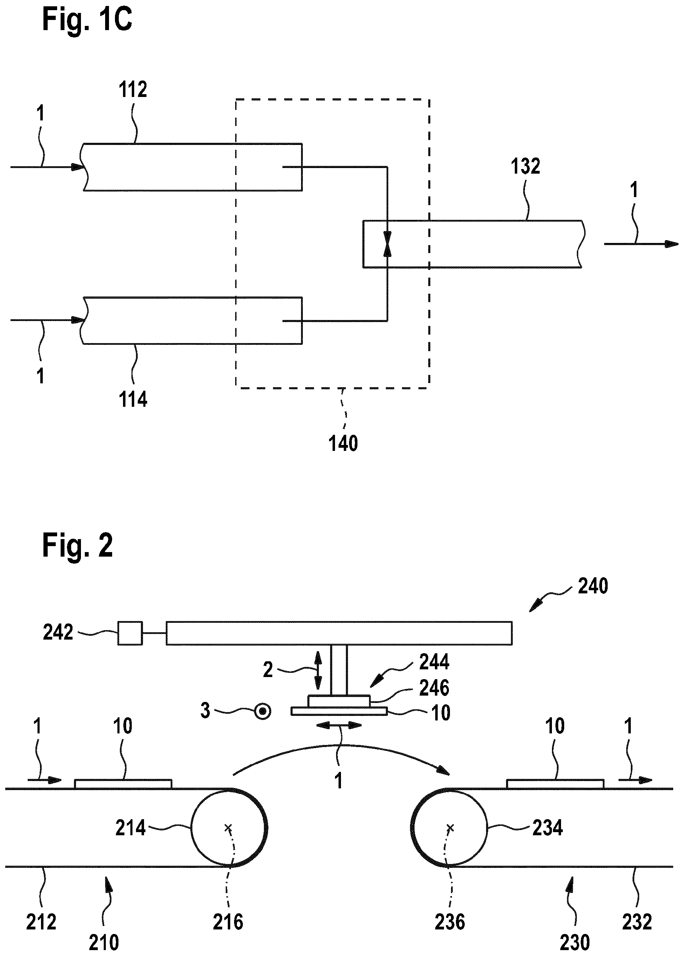

FIGs. 1B and C show schematic views of a transfer of solar cells from the first transport line 112 and the second transport line 114 to the third transport line 132 according to embodiments described herein. The transfer module 140 has at least one transfer device, such as vacuum grippers, electrostatic grippers or electrodynamic grippers, configured for moving the solar cells from the first transport line 112 and the second transport line 114 to the third transport line 132.

The dual-line transport arrangement (i.e., the first transport line 112 and the second transport line 114) and the single-line transport arrangement (i.e., the third transport line 132) provide respective transport directions for the solar cells. The transport directions provided by the first transport line 112, the second transport line 114, and the third transport line 132 can be substantially parallel (in the following commonly referred to as "the transport direction 1"). In some embodiments, the transport direction 1 is a horizontal direction.

According to some embodiments, which can be combined with other embodiments described herein, the third transport line 132 can be positioned between the first transport line 112 and the second transport line 114. In some embodiments, the first transport line 112 and the second transport line 114 can overlap with the third transport line 132 in the transport direction 1 (FIG. 1B). In other embodiments, the first transport line 112 and the second transport line 114 do not overlap with the third transport line 132 in the transport direction 1 (FIG. 1C). In other words, the first transport line 112 and the second transport line 114 are spaced apart from the third transport line 132 in the transport direction 1.

As shown in FIG. 1B, according to one embodiment, the first transport line 112 and the second transport line 114 overlap with the third transport line 132 in the transport direction 1. The transfer module 140, and particularly the at least one transfer device, can be configured for laterally displacing the solar cells from the first transport line 112 and the second transport line 114 to the third transport line 132, or vice versa. The transfer module 140 can move or transfer the solar cells in a direction substantially perpendicular to the transport direction 1 in order to laterally displace the solar cells onto the third transport line 132.

As shown in FIG. 1C, according to another embodiment, the first transport line 112 and the second transport line 114 are spaced apart from the third transport line 132 in the transport direction 1. The transfer module 140, and particularly the at least one transfer device, can be configured to move the solar cells parallel and perpendicular to the transport direction 1 to move or transfer the solar cells from the first transport line 112 and the second transport line 114 to the third transport line 132. The transfer module 140 can simultaneously or sequentially move or transfer the solar cells parallel and perpendicular to the transport direction 1 in order to move the solar cells to the third transport line 132. FIG. 1C illustrates an example in which the transfer module 140 sequentially moves the solar cells parallel and perpendicular to the transport direction 1.

FIG. 2 shows a schematic side view of a transfer module 240 for transferring solar cells 10 between transport lines according to embodiments described herein. In FIG. 2, only the first transport line 210 of the two dual-line transport arrangement and the third transport line 230 of the single-line transport arrangement are shown for illustrative purposes.

The transfer module 240 has at least one transfer device 244 configured for moving the solar cells 10 from the first transport line 210 and the second transport line to the third transport line 230, or vice versa. According to some embodiments, which can be combined with other embodiments described herein, the at least one transfer device 244 is a first transfer device and a second transfer device. The first transfer device is configured for moving solar cells 10 from the first transport line 210 to the third transport line 230. The second transfer device is configured for moving solar cells 10 from the second transport line to the third transport line 230. The first transfer device and the second transfer device can be configured substantially identical. In some implementations, the first transfer device and the second transfer device can operate synchronously. According to some embodiments, the at least one transfer device 244 can be configured for at least one of aligning the solar cells and releasing the solar cells in a predetermined position on the third transport line 230.

According to some embodiments, which can be combined with other embodiments described herein, the at least one transfer device 244 is selected from the group consisting of a gripper, a mechanical gripper, a vacuum gripper, a Bernoulli-type holder, an electrostatic gripper, an electrodynamic gripper, and any combination thereof. The mechanical gripper can use mechanical devices, such as clamps, to hold the solar cell at the gripper. The vacuum can use a suction force to hold the solar cell at the gripper. The Bernoulli-type holder uses an air flow to create a reduced pressure at a surface of the solar cell in order to hold the solar cell at the gripper. The electrostatic grippers and electrodynamic grippers can use an electrostatic force and an electrodynamic force, respectively, to hold the solar cell at the gripper.

In some implementations, the at least one transfer device 244, and particularly the gripper, can include one or more gripper elements 246 configured for contacting and gripping a solar cell 10. As an example, the gripper can include two or more, such as three, four, five or six gripper elements configured for contacting and gripping a solar cell. As an example, the one or more gripper elements 246 can be suction cups configured to provide an under-pressure at a surface of the solar cell to hold the solar cell at the one or more gripper elements 246.

The at least one transfer device 244 is configured for moving or transferring the solar cells from the first transport line 210 and the second transport line to the third transport line 230. In some embodiments, the at least one transfer device 244 can substantially simultaneously grip or pick up the solar cells 10 from the first transport line 210 and the second transport line, for example, when the at least one transfer device 244 includes the first transfer device for moving solar cells 10 from the first transport line 210 to the third transport line 230 and the second transfer device for moving solar cells 10 from the second transport line to the third transport line 230. In other embodiments, the at least one transfer device 244 can alternately grip or pick up the solar cells 10 from the first transport line 210 and the second transport line, for example, when the at least one transfer device 244 includes only one transfer device for moving solar cells 10 from the first transport line 210 and the second transport line to the third transport line 230.

According to some embodiments, the apparatus includes a controller 242 configured to control the at least one transfer device 244. In particular, the controller 242 can control a movement of the at least one transfer device 244 for transferring the solar cells 10 from the dual-line transport arrangement to the single-line transport arrangement.

In some implementations, the at least one transfer device 244 is movable in at least one of a first direction, which can correspond to the transport direction 1, a second direction 2, and a third direction 3. The first direction and the third direction 3 can be substantially horizontal directions. In other words, the first direction and the second direction 2 can define a horizontal plane. The second direction 2 can be a vertical direction. The at least one transfer device 244 can be movable sequentially or simultaneously in at least one of the first direction, the second direction 2, and the third direction 3. By the movement in the first direction, the second direction 2, and the third direction 3, the solar cells 10 held by the at least one transfer device 244 can be moved from the first transport line 210 and the second transport line to the third transport line 230.

As an example, the at least one transfer device 244 can move in the second direction 2, for example, upwards, to pick up a solar cell 10 from the first transport line 210 or second transport line. The at least one transfer device 244 can then sequentially or simultaneously move in the first direction and the third direction 3, for example, in the horizontal plane, to move the solar cell piece to the third transport line 230. The at least one transfer device 244 can move in the second direction 2, for example, downwards, to place the solar cell 10 on the third transport line 230. The at least one transfer device 244 can then move in the second direction 2 (e.g., upwards), the first direction and the third direction 3 back to the first transport line 210 or the second transport line to pick up another solar cell 10 from the first transport line 210 or the second transport line. It is noted that movements in the "first direction" shall embrace forward and backward movements, movements in the "second direction" shall embrace upward and downward movements, and movements in the "third direction" shall embrace left and right movements. The movements can be defined with respect to the forward transport direction.

The term "vertical direction" is understood to distinguish over "horizontal direction". That is, the "vertical direction" relates to a substantially vertical movement, wherein a deviation of a few degrees, e.g. up to 5° or even up to 10°, from an exact vertical direction is still considered as a" substantially vertical direction". The vertical direction can be substantially parallel to the force of gravity.

In some implementations, the transfer module 240, and particularly the at least one transfer device 244, can be configured for alignment of the solar cell held by the at least one transfer device 244 before the solar cell 10 is put on the third transport line 230. The apparatus can use information acquired by a detection system (not shown) which can include, for example, one or more cameras configured to detect a position and/or orientation of the solar cell 10 held by the at least one transfer device 244.

In some implementations, the at least one transfer device 244 is configured to align the solar cell 10 in a plane, such as a substantially horizontal plane. Such a movement can also be referred to as "Θ movement" or "Θ alignment". As an example, the at least one transfer device 244 can be configured to adjust or align an angular orientation of a solar cell 10 held by the at least one transfer device 244 in the plane.

According to some embodiments, which can be combined with other embodiments described herein, the first transport line 210 and/or the second transport line of the dual-line transport arrangement can include, or be, a belt conveyor having a roller 214 rotatable around a rotational axis 216 and one or more belts 212 provided on the roller 214. The one or more belts 212 are configured for supporting the solar cells 10 during transportation thereof in the transport direction 1, which can be a substantially horizontal direction.

According to some embodiments, which can be combined with other embodiments described herein, the third transport line 230 of the single-line transport arrangement can include, or be, a belt conveyor having a roller 234 rotatable around a rotational axis 236 and one or more belts 232 provided on the roller 234. The one or more belts 232 are configured for supporting the solar cells 10 during transportation thereof in the transport direction 1, which can be the substantially horizontal direction.

In some implementations, at least one of the dual-line transport arrangement and the single-line transport arrangement includes one or more guide rails and shuttles movable along the one or more guide rails. The shuttles are configured for supporting and transporting the solar cells along the guide rails. As an example, the first transport line, the second transport line and/or the third transport line are provided by respective guide rails. The transfer device can be configured for transferring the solar cells from shuttles of the first transport line and the second transport line to shuttles of the third transport line.

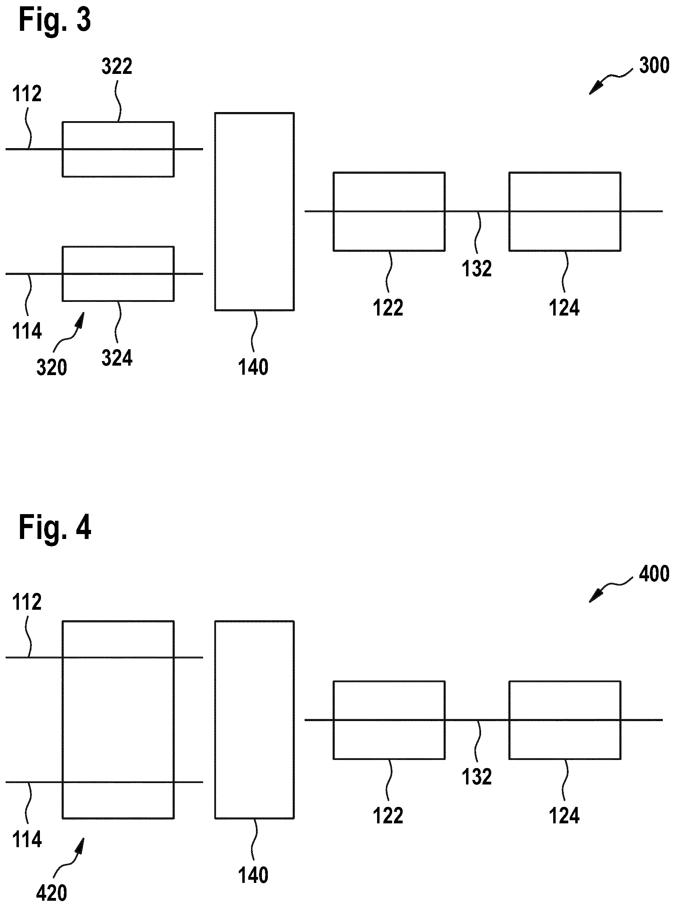

FIG. 3 shows a schematic top view of an apparatus 300 for processing of solar cells according to further embodiments described herein.

The apparatus 300 includes the at least one first process station 320, the transfer module 140, and the at least one second process station 122. The at least one first process station 320, the transfer module 140, and the at least one second process station 122 can be sequentially arranged, for example, along the transport direction. According to some embodiments, the first transport line 112, the second transport line 114, and/or the third transport line can extend into the transfer module 140.

In some implementations, the apparatus 300 includes a further process station 124 downstream of the at least one second process station 122. As an example, the at least one first process station 320, the transfer module 140, the at least one second process station 122, and the further process station 124 can be sequentially arranged, for example, along the transport direction. According to some embodiments, the at least one first process station 320 can be the electrical testing station, the at least one second process station 122 can include, or be, the optical inspection station, and the further process station 124 can be the sorting station.

In the example of FIG. 3, the at least one first process station 320 includes a first sub-station 322 at the first transport line 112 and a second sub-station 324 at the second transport line 114. The first sub-station 322 and the second sub-station 324 can be separate or independent process stations. In particular, the first sub-station 322 and the second sub-station 324 can be configured substantially identical. As an example, each of the first sub-station 322 and the second sub-station 324 can include a respective light source, such as a solar simulator, and contact elements to provide electrical connections to the solar cells, for example, for I/V testing.

The at least one first process station 320 can have a first throughput rate for each of the first transport line 112 and the second transport line 114. The second process station can have a second throughput rate for the third transport line 132. The first throughput rate can be less than the second throughput rate. Using the dual-line transport arrangement for the at least one first process station 320 having the low throughput rate and the single-line transport arrangement for the at least one second process station 122 (and optionally the further process station 124) having the higher throughput rate can reduce a footprint and complexity of the apparatus 300 while providing a high overall throughput of the apparatus 300. In particular, the first throughput rates of the at least one first process station 320 at the first transport line 112 and the second transport line 114 can add up, for example, to substantially match the second throughput rate of the at least one second process station 122.

FIG. 4 shows a schematic top view of an apparatus 400 for processing of solar cells according to yet further embodiments described herein.

In the example of FIG. 4, the at least one first process station 420 provided is one single station extending across the first transport line 112 and the second transport line 114. As an example, the at least one first process station 420 can include one single light source, such as a solar simulator extending above and/or across the first transport line 112 and the second transport line 114. In particular, the same light source or lamp can be used for testing solar cells on both the first transport line 112 and the second transport line 114.

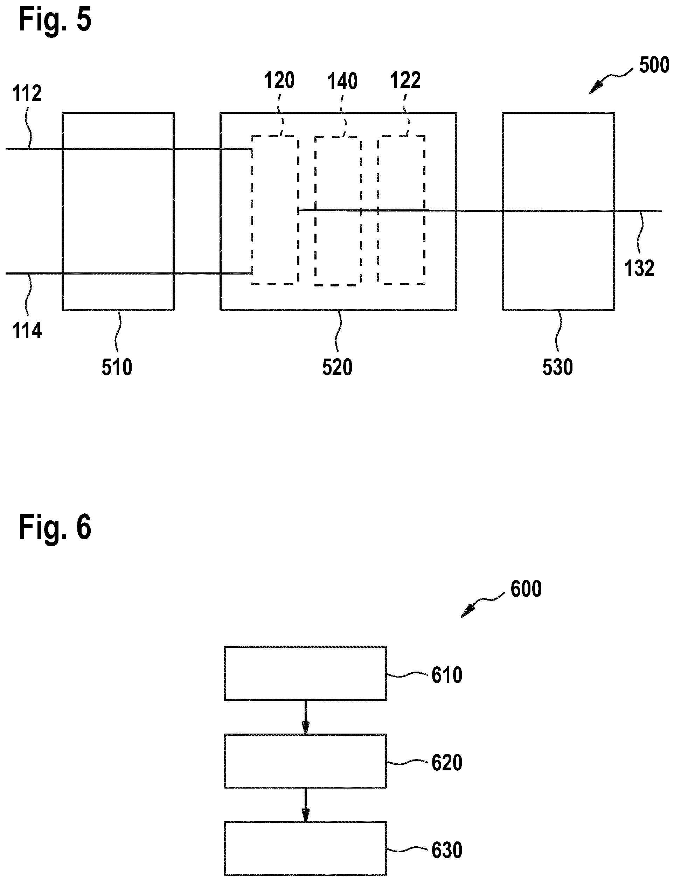

FIG. 5 shows a schematic top view of a system 500 for the manufacture of solar cells according to embodiments described herein.

The system 500 includes one or more production stations 510 for producing solar cells, and the apparatus 520 for processing of solar cells according to the embodiments described herein. The apparatus 520 is configured for testing and/or inspecting solar cells produced by the one or more production stations 510. The first transport line 112 and the second transport line 114 of the dual-line transport arrangement can extend through at least one production station of the one or more production stations 510.

According to some embodiments, the one or more production stations are selected from the group consisting of a printing station, a drying station, a buffer station, and any combination thereof. As an example, the one or more production stations 510 include a printing station and optionally a drying station. The solar cells having conductive lines printed thereon can then be introduced into the apparatus 520 for testing and/or inspection. After testing and/or inspection, the solar cells can then be provided to a sorting station 530 for sorting the solar cells based on results obtained during the testing and/or inspection.

FIG. 6 shows a flow chart of a method 600 for testing solar cells according to embodiments described herein. The method 600 can be implemented using the apparatuses and systems according to the embodiments of the present disclosure.

The method 600 includes in block 610 a performing of a first testing procedure on the solar cells arranged on a first transport line and a second transport line of a dual-line transport arrangement, in block 620 a moving of the solar cells positioned on the first transport line and the second transport line to a third transport line of a single-line transport arrangement, and in block 630 a performing of a second testing procedure on the solar cells arranged on the third transport line.

In some implementations, the first testing procedure includes a measuring of electrical characteristics of the solar cells using, for example, a first process station of the at least one first process station, which can be an electrical testing station. As an example, the first testing procedure can include an I/V testing. The second testing procedure can include an optical inspection of the solar cells using, for example, a second process station of the at least one second process station, which can be an optical inspection station.

According to embodiments described herein, the method for testing solar cells can be conducted using computer programs, software, computer software products and the interrelated controllers, which can have a CPU, a memory, a user interface, and input and output device being in communication with the corresponding components of the apparatus for processing, such as testing, of solar cells.

The present disclosure uses a combination of a dual-line transport arrangement and a single-line transport arrangement with a transfer module arranged therebetween. The dual-line transport arrangement and the single-line transport arrangement can be sequentially arranged, wherein the transfer module moves solar cells from the dual-line transport arrangement to the single-line transport arrangement. A footprint of the apparatus, a space for installation, and/or costs can be reduced. Further, one or more process stations having a high throughput rate can be arranged along the single-line transport arrangement and/or one or more process stations having a lower throughput rate can be arranged along the dual-transport arrangement. An overall throughput of the apparatus can thus be high.

While the foregoing is directed to embodiments of the disclosure, other and further embodiments of the disclosure may be devised without departing from the basic scope thereof, and the scope thereof is determined by the claims that follow.

## Claims

1. An apparatus (100) for processing of solar cells (10), comprising:
a dual-line transport arrangement (110) having a first transport line (112) and a second transport line (114) configured for transportation of the solar cells;
at least one first process station (120) at the dual-line transport arrangement;
a single-line transport arrangement (130) having a third transport line (132) configured for transportation of the solar cells;
at least one second process station (122) at the single-line transport arrangement (130); and
a transfer module (140) between the at least one first process station (120) and the at least one second process station (122), wherein the transfer module is configured for transferring the solar cells from the first transport line and the second transport line to the third transport line, or vice versa.

2. The apparatus of claim 1, wherein the transfer module has at least one transfer device configured for moving the solar cells from the first transport line and the second transport line to the third transport line, or vice versa.

3. The apparatus of claim 2, wherein the at least one transfer device is configured for laterally displacing the solar cells from the first transport line and the second transport line to the third transport line, or vice versa.

4. The apparatus of claim 2 or claim 3, wherein the at least one transfer device is a first transfer device and a second transfer device, wherein the first transfer device is configured for moving solar cells from the first transport line to the third transport line, and wherein the second transfer device is configured for moving solar cells from the second transport line to the third transport line.

5. The apparatus of any of the preceding claims, wherein the at least one transfer device is selected from the group consisting of a gripper, a mechanical gripper, a vacuum gripper, a Bernoulli-type holder, an electrostatic gripper, an electrodynamic gripper, and any combination thereof.

6. The apparatus of any of the preceding claims, wherein the at least one first process station is selected from the group consisting of an electrical testing station, an optical inspection station, a printing station, a drying station, a sorting station, and any combination thereof.

7. The apparatus of any of the preceding claims, wherein the at least one second process station is selected from the group consisting of an electrical testing station, an optical inspection station, a printing station, a drying station, a sorting station, and any combination thereof.

8. The apparatus of any of the preceding claims, further including a sorting station downstream of the at least one second process station.

9. The apparatus of any one of the preceding claims, wherein the first transport line and the second transport line extend next to each other and/or parallel to each other.

10. A system (500) for the manufacture of solar cells, comprising:
one or more production stations (510) for producing the solar cells; and
the apparatus (100) of any of the preceding claims, wherein the apparatus is configured for testing and/or inspecting the solar cells (10) produced by the one or more production stations.

11. The system of claim 10, wherein the first transport line and the second transport line of the dual-line transport arrangement extend through at least one production station of the one or more production stations.

12. The system of claim 10 or 11, wherein the one or more production stations are selected from the group consisting of a printing station, a drying station, a buffer station, and any combination thereof.

13. A method for testing solar cells, comprising:
performing a first testing procedure on the solar cells arranged on a first transport line and a second transport line of a dual-line transport arrangement;
moving the solar cells positioned on the first transport line and the second transport line to a third transport line of a single-line transport arrangement; and
performing a second testing procedure on the solar cells arranged on the third transport line.

14. The method of claim 13, wherein the first testing procedure includes a measuring of electrical characteristics of the solar cells.

15. The method of claim 13 or 14, wherein the second testing procedure includes an optical inspection of the solar cells.
